(19) Europäisches Patentamt
European Patent Office
Office européen des brevets

(11) **EP 4 644 914 A1**

(12) **EUROPÄISCHE PATENTANMELDUNG**

(43) Veröffentlichungstag:
**05.11.2025   Patentblatt 2025/45**

(21) Anmeldenummer: **24173403.7**

(22) Anmeldetag: **30.04.2024**

(51) Internationale Patentklassifikation (IPC):
**G01R 15/14** (2006.01)     **G01R 15/16** (2006.01)
**G01R 29/12** (2006.01)     **G01R 19/00** (2006.01)

(52) Gemeinsame Patentklassifikation (CPC):
**G01R 15/144; G01R 15/165; G01R 29/12;**
G01R 19/0084

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft**
**80333 München (DE)**

(72) Erfinder:
• **Gashi, Indrit**
  **81241 München (DE)**
• **Raab, Oliver**
  **94496 Ortenburg (DE)**
• **Santos Wilke, Hans**
  **85599 Parsdorf (DE)**
• **Weikert, Robert**
  **92342 Burggriesbach (DE)**

(74) Vertreter: **Siemens Patent Attorneys**
**Postfach 22 16 34**
**80506 München (DE)**

(54) **VORRICHTUNG UND VERFAHREN ZUR BESTIMMUNG EINER ELEKTRISCHEN GRÖSSE EINES ZU VERMESSENDEN ELEKTRISCHEN LEITERS**

(57) Es wird eine Vorrichtung und ein Verfahren zur berührungslosen Bestimmung einer elektrischen Größe eines zu vermessenden elektrischen Leiters (con) vorgeschlagen. Mit einer Anordnung von Feldmesseinrichtung/en (S1, S2) mit wenigstens einer metallischen Abschirmung an dem zu vermessenden elektrischen Leiter (con) werden zwei Messungen des elektrischen Feldes (E1, E2) vorgenommen. Durch die bekannte Größe, die die metallische Abschirmung mit ihrer Dicke ($d_{met}$) in die Vergleichsmessung einbringt, kann das ratiometrische Messprinzip angewendet werden und, unabhängig von Kenntnissen über den Abstand der Feldmessvorrichtung vom elektrischen Leiter (con), eine elektrische Größe, insbesondere die anliegende Spannung (U) am Leiter, genau bestimmt werden.

FIG 1

EP 4 644 914 A1

**Beschreibung**

Die Erfindung betrifft eine Vorrichtung umfassend wenigstens eine berührungslose Messeinrichtung zur Messung einer elektrischen Größe eines zu vermessenden elektrischen Leiters sowie ein Verfahren zur berührungslosen Messung und Bestimmung einer elektrischen Größe eines stromdurchflossenen elektrischen Leiters.

Die exakte Bestimmung elektrischer Größen wie elektrischer Strom, elektrische Spannung, elektrischer Energiefluss, ist eine wichtige Aufgabe für unterschiedliche Anwendungsfelder, beispielsweise in der industriellen Automatisierung, der Gebäudetechnik oder auch in großflächigen elektrischen Verteilernetzen. Insbesondere im Zuge der voranschreitenden Umstellung auf erneuerbare Energien und der Dezentralisierung der Energieerzeugung wird es in Zukunft von entscheidender Bedeutung sein, elektrische Größen von stromführenden Bauteilen exakt und örtlich aufgelöst abbilden zu können. Insbesondere in der industriellen Automatisierung, sei es in Schaltanlagen oder kleiner dimensioniert auf Leiterplatten wird es zunehmend wichtiger elektrische Größen von stromführenden Bauteilen zuverlässig bestimmen zu können.

Zur Durchführung von Strommessungen stehen bereits unterschiedliche Messverfahren zur Verfügung. Bekannt sind als berührungslose Messmethoden beispielsweise Hall-Sensoren oder Rogowski-Spulen. Auch im Bereich der Spannungsmessung sind bereits berührungslose Verfahren bekannt. Beispielsweise das Prinzip des Elektroskops oder das des Voltmeters, insbesondere der Einsatz eines mikroelektromechanischen Voltmeters, auch bezeichnet als mikroelektromechanische Feldmühle. Dieses Messprinzip beruht auf einer Messung der zeitlichen Veränderung einer elektrischen Kapazität mittels eines mikroelektromechanischen Systems. Die zeitliche Veränderung beziehungsweise Abschattung der Kapazität wird mechanisch mit einem elektrischen, elektrostatischen oder thermischen Aktor herbeigeführt. Um die Veränderung der Kapazität zu messen, wird ein Verschiebungsstrom durch einen Strom-Spannungs-Wandler erfasst und hierdurch ein Messsignal generiert. Der Einfluss der zu messenden elektrischen Spannung auf das Messergebnis wird dadurch eliminiert, dass die Spannung konstante Teile enthält und der Strom-Spannungs-Wandler während der Schaltflanken der Spannung abgetastet wird. So kann eine Impulsantwort auf Spannungsänderungen der zu messenden Spannung, die auch auf den Messkondensator wirken, ausgeblendet werden.

Es wird also die Eigenschaft des kapazitiven Messprinzips genutzt, dass ein Signal nur detektiert werden kann, wenn sich am Kondensator Ladungen verschieben, die einen Verschiebungsstrom I von t initiieren. Hierfür gilt die Gleichung $I(t) = dC/dt \cdot U + dU/dt \cdot C$, wobei C die Kapazität des Kondensators ist und U die am Kondensator anliegende Spannung. Die Kapazität des Kondensators, bzw. die Kapazität zwischen einem Messobjekt, beispielsweise einem stromführenden Leiter, und dem Sensor, insbesondere einem mikroelektromechanischen Voltmeter, kann durch Änderung der Fläche der Kondensatorplatten, insbesondere durch Einschieben von Blenden in den Kondensatorspalt, durch Änderung des Abstands der Kondensatorplatten oder durch Änderung der relativen Dielektrizitätskonstante des zwischen den Platten befindlichen Mediums geändert werden, was aus den Anmeldungsschriften DE102010035381A1 und DE102008052477A1 bekannt ist.

Waren bisherige bewehrte Spannungsmessungen in den meisten Fällen berührende Verfahren, beispielsweise mit einem Analog-Digital-Konverter, kann mittels einer Feldmühle ein berührungsloses Verfahren realisiert werden.

Berührendes Verfahren heißt, dass ein physischer Kontakt zum Messobjekt hergestellt werden muss, um eine direkte Messung im Stromkreis vorzunehmen. Hierzu muss also eine Messvorrichtung entweder fest integriert sein oder alternativ die Isolation der zu messenden elektrischen Leitung unterbrochen, d. h. beschädigt werden. Dieser notwendige direkte physische Kontakt zur stromführenden Leitung hat insbesondere bei bereits bestehenden Anlagen ("Brownfield") den Nachteil, dass diese Verfahren zur Vornahme einer Messung oder zur Installation zwischenzeitlich vom Netz getrennt werden müssen und im späteren Betrieb strenge Sicherheitsanforderungen eingehalten werden müssen, was die elektrische Sicherheit betrifft. Auch für die Datenübertragung muss eine galvanische Trennung realisiert werden. Unter einem berührungslosen Verfahren wird ein Verfahren bzw. eine Vorrichtung angesehen oder verstanden, welche mit dem zu vermessenden elektrischen Leiter galvanisch getrennt angeordnet ist. Das heißt die Messung an dem elektrischen Leiter wird dadurch vorgenommen, dass das elektrische Feld oder das elektromagnetische Feld, welches vom stromdurchflossenen Leiter ausgeht, mittels eines Sensors erfasst wird. Unter galvanisch getrennt ist also zu verstehen, dass es zwar eine Potentialauswirkung gibt, also dass das elektrische Feld oder ein elektromagnetisches Feld von einem Sensor erfasst werden kann, aber es liegt eine elektrische Isolation vor, so dass kein Strom zwischen dem zu vermessenden Leiter und der Vorrichtung, insbesondere der Messvorrichtung, fließen kann.

Derartige berührungslose Messverfahren sind von großem Vorteil für den Einsatz in bestehenden Systemen, weil diese ohne baulichen Eingriff mit einer Messvorrichtung nachgerüstet werden können. Eine Schwierigkeit dieser berührungslosen Messung jedoch liegt darin, dass bei Messungen nur einer elektrischen Größe, beispielsweise der elektrischen Feldstärke, der Abstand der Messposition also des Sensors zum Messbereich des zu vermessenden elektrischen Leiters höchstgenau sein muss und ebenso exakt reproduzierbar sein muss. Diese Notwendigkeit stellt hohe Anforderungen an mechanische Realisierungen und Einbautoleranzen.

Folglich stellt es sich als technisch erforderlich dar, eine verbesserte Lösung vorzuschlagen, welche die aus dem Stand der Technik bekannten Nachteile vermeidet. Insbesondere soll die vorzuschlagende Lösung eine genauere Bestimmung einer elektrischen Größe ermöglichen.

Diese der vorliegenden Erfindung zugrunde liegenden Aufgaben werden durch eine Vorrichtung gemäß dem Patentanspruch 1 und durch ein Verfahren gemäß dem Patentanspruch 12 gelöst. Vorteilhafte Ausgestaltungen der Erfindung sind Gegenstand der Unteransprüche.

Beschreibung der Erfindung

Die erfindungsgemäße Vorrichtung umfasst wenigstens eine Feldmesseinrichtung zur Messung eines elektrischen Feldes eines zu vermessenden elektrischen Leiter, wobei die Feldmesseinrichtung an dem zu vermessenden elektrischen Leiter galvanisch getrennt zu diesem positionierbar ist, dadurch gekennzeichnet, dass die wenigstens eine Feldmesseinrichtung mit einer metallischen Abschirmung bekannter Dicke $d_{met}$ angeordnet ist, so dass zwei Messungen des elektrischen Feldes des zu vermessenden Leiters mit unterschiedlichem effektiven Abstand $d_{eff}$ zwischen Feldmesseinrichtung und Leiter vornehmbar sind.

Innerhalb von elektrisch leitfähigen Metallen baut sich zwischen den mechanischen Grenzflächen kein elektrisches Feld aus. Das E-Feld ist in diesem Bereich 0. Der Abstand zwischen Feldmesseinrichtung und Leiter verkürzt sich, aus Feldlinien Sicht, genau um die Dicke des eingebrachten Metalls. Ist also die Feldmesseinrichtung so mit der metallischen Abschirmung angeordnet, dass das Metall zwischen dem das elektrische Feld erzeugenden elektrischen Leiter und der Messsensorik liegt, wird ein Wert für das elektrische Feld erfasst, welcher einem geringeren Abstand zwischen Feldmesseinrichtung und Leiter entspräche, also einem effektiven Abstand von $d_{eff} = d_0 - d_{met}$, wobei $d_0$ der tatsächlich, aber unbekannte Abstand zwischen Leiter und Sensor ist.

Diese Tatsache wird nun in Kombination mit einer Feldmesseinrichtung genutzt: Um auf die Leiterspannung schließen zu können ohne, dass der Abstand zwischen Leiter und Feldmühle bekannt ist. Mittels einer ratiometrischen Messung, bei der zwei geeignete Messungen zueinander ins Verhältnis gesetzt werden kürzt sich rechnerisch der mechanische Abstand $d_0$ heraus. Konkret erfolgt dies hier durch die Einbringung eines definierten metallischen Werkstoffes genauer Dicke in das elektrische Feld zwischen Leiter und Feldmühle. Das elektrische Feld innerhalb dieses Werkstoffes wird zu 0.

Das ratiometrische Messprinzip ist ein Verfahren zur Messung einer physikalischen Größe, bei dem die Ausgangsspannung oder der Ausgangswert des Sensors im Verhältnis zu einer Referenzspannung oder einem Referenzwert gemessen wird. Bei diesem Prinzip wird die gemessene Größe in Bezug zu einem festgelegten Bezugswert angegeben, anstatt einen absoluten Wert zu liefern. Dies hat den Vorteil, dass Schwankungen der Versorgungsspannung oder des Umgebungseinflusses minimiert werden können, da sie sowohl den Messwert als auch die Referenzspannung gleichermaßen beeinflussen. Dadurch wird die Genauigkeit und Zuverlässigkeit der Messung verbessert.

Grundsätzlich ist die Realisierung eines ratiometrischen Messprinzip auch durch Verwendung von mehreren Sensoren an unterschiedlichen Positionen möglich, bei dem sich der Abstand der Sensoren zum Leiter in der Rechnung herauskürzt. Die vorgeschlagene Lösung hat demgegenüber den Vorteil, mit wenigen, einer oder zwei diskreten Feldmesseinrichtungen auszukommen und dadurch den Schaltungsaufwand zur Auswertung enorm zu minimieren. Dies senkt die Kosten und es ist durch die Reduktion der Komponenten ein hoher Integrationsgrad realisierbar.

In einer vorteilhaften Ausführungsform der Erfindung umfasst die Vorrichtung eine Messsignalverarbeitungseinrichtung, welche ausgestaltet ist, aus den Messungen eine weitere elektrische Größe zu bestimmen. Und besonders vorteilhaft ist dabei die Feldmesseinrichtung als mikroelektromechanische Feldmühle ausgestaltet ist.

Generell kann damit zwei Messungen mittels zwei getrennter Sensoren oder mittels eines Sensors, einmal mit und einmal ohne die metallische Abschirmung im Messabstand erfolgen. Dafür würde beispielsweise mittels einer mechanischen Vorrichtung der metallische Werkstoff in den Messabstand eingebracht und wieder entfernt werden.

Zur einfacheren Herleitung wird von zwei getrennten Feldsensoren ausgegangen, mit denen jeweils eine elektrische Feldstärke $E_1$ und $E_2$ erfasst wird.

Die elektrischen Felder $E_1$ und $E_2$ ergeben sich zu:

$$E_1 = \frac{U}{d_0}$$

sowie

$$E_2 = \frac{U}{d_0 - d_{met}}$$

Dabei ist $d_0$ der unbekannte Abstand zwischen Sensoren und Leiter, $d_{met}$ die Dicke der metallischen Abschirmung.

$$d_0 = \frac{U}{E_1}$$

eingesetzt in $E_2$ ergibt dann:

$$U \frac{E_2}{E_1} - U = E_1 * d_m$$

Und folglich:

$$U = \frac{E_1 * E_2 * d_m}{E_2 - E_1}$$

Damit kann die am Leiter anliegende Spannung U rein aus den beiden Messgrößen $E_1$ und $E_2$ sowie der bekannten Dicke des Metalls $d_{met}$ bestimmt werden. Neben der konkreten Anwendung auf einen Feldmühlen-Sensor trifft dieses Prinzip auf alle E-Feld-Sensoren zu.

Insbesondere weisen die Feldmesseinrichtungen eine elektromagnetische Feldabschirmung (EMC) auf. Da auf beide Messgrößen eine Vielzahl an Störvariablen einwirken, müssen technische Maßnahmen ergriffen werden, um deren Einfluss zu minimieren. Ein Beispiel für diese variablen Störgrößen ist, dass bei einer E-Feld-Messung, der Abstand zum zu messenden Leiter direkt in das Messsignal mit eingeht. Aber auch andere Effekte, wie die geometrische Ausrichtung des Leiters zu den Sensoren oder Störfelder, führen zu fehlerbehafteten, unpräzisen Messungen. Demnach werden die Messvorrichtungen gegen externe Störgrößen, z.B. durch externe E- und B-Felder, entsprechend abgeschirmt.

In einer weiteren vorteilhaften Ausführungsform der Erfindung umfasst die erfindungsgemäße Vorrichtung, insbesondere nach einer vorstehend beschriebenen Ausgestaltung, wenigstens eine Feldmesseinrichtung, welche als Sensorchip ausgeführt ist und insbesondere in einem Chipgehäuse angeordnet ist. Derartige Ausführungen als Sensorchip ermöglichen vielfältige Gestaltungsmöglichkeiten bezüglich der Anordnung, z.B. auf Leiterplatten oder anderen Substraten, oder Integrationsmöglichkeiten, z.B. in integrierte Schaltkreise, Module oder Baugruppen.

Besonders zweckdienlich ist die Ausgestaltung der erfindungsgemäßen Vorrichtung mit einer Messsignalverarbeitungseinrichtung, welche eine Auswerteelektronik umfasst. Insbesondere ist von der Auswerteelektronik eine Rechenlogik umfasst, welche zur Ausgabe digitaler Werte geeignet ist. Vorteilhaft ist dabei von der Messsignalverarbeitungseinrichtung auch eine Signalaufbereitung umfasst. Insbesondere umfasst die Signalaufbereitung zumindest eine Signalverstärkung. Signalaufbereitungsvorrichtungen müssen je Sensor vorgesehen sein, die Auswerteelektronik wertet die Messsignale beider Sensoren aus und bestimmt daraus einen weiteren elektrischen Größe. Hiermit wird vorteilhaft eine berührungslose und sogar abstandsunabhängige Spannungsermittlung realisiert.

In einer bevorzugten Ausführungsform sind in der erfindungsgemäßen Vorrichtung, insbesondere nach einer der vorstehend beschriebenen Varianten, zwei Feldmesseinrichtungen nebeneinander angeordnet, so dass beide denselben Abstand zum zu vermessenden elektrischen Leiter aufweisen. Dabei ist eine der Feldmesseinrichtungen mit der metallischen Abschirmung angeordnet. Insbesondere sind die beiden Sensoreinheiten dazu auf einem gemeinsamem Substrat, z.B. einer Leiterplatte angeordnet. Es ist dabei jedoch kein gemeinsames Potential notwendig und keine elektrische Verbindung notwendig. Auch eine Anordnung auf einem isolierenden Substrat wäre möglich. Hauptaufgabe des Substrats ist die akkurate Positionierung nebeneinander.

Bei dieser Ausführungsform ist der Integrationsgrad extrem hoch. Beide Sensoren bedürfen nicht einmal eines bekannten Bezugspotentials, wie Simulationsergebnisse unterstreichen. Baulich bedeutet das, dass die Vorrichtung kabellos realisiert werden kann. Arbeitet man mit zwei Sensoren vermindert man den Bedarf an beweglichen Bauteilen. Die Bestimmung weiterer elektrischer Größen aus den Feldmesswerten ist höchst zuverlässig.

In einer alternativen Ausführungsform umfasst die erfindungsgemäße Vorrichtung eine Feldmesseinrichtung, welche zwischen zwei Messpositionen beweglich angeordnet ist, wobei eine der Messpositionen durch die metallische Abschirmung abgeschirmt ist.

In einer weiteren alternativen Ausführungsform umfasst die erfindungsgemäße Vorrichtung eine Feldmesseinrichtung, welche mit einer beweglichen metallischen Abschirmung angeordnet ist. Diese Ausgestaltungsform birgt den Vorteil vieler Variationsmöglichkeiten, zum Beispiel auch mit unterschiedlichen Dicken der metallischen Abschirmung.

In einer weiteren sehr vorteilhaften Ausgestaltung der Erfindung liegt die Vorrichtung in einem Gehäuse vor. Dies kann beispielsweise ein Kunststoffgehäuse sein. Eine derartige Einhausung ist besonders dadurch möglich, dass die Vorrichtung ohne Potentialbezug nach Außen, ohne elektrischen Kontakt, ohne Kabel ausgeführt sein kann. Eine derartige Vorrichtung kann besonders gut nachgerüstet werden, z.B. in Schaltanlagen, ist grundsätzlich relativ einfach integrierbar und kann durch das Gehäuse besonders robust ausgestaltet werden, z.B. in Außenanwendungen.

Des Weiteren kann eine erfindungsgemäße Ausführungsform der Vorrichtung vorsehen, dass die metallische Abschirmung bekannter Dicke am Gehäuse der Vorrichtung, insbesondere an der Gehäuseinnenseite oder an beziehungsweise auf einem der Chipgehäuse der Sensorchips aufgebracht ist. Dabei kann es sich bei der metallischen Abschirmung um ein dickeres Metallstück, ein Metallplättchen oder eine direkt aufgebrachte Metallschicht handeln. Unter metallische Abschirmung werden auch Abschirmungen aus metallischen Werkstoffen verstanden, welche zusätzlich nicht-metallische Materialien aufweisen. Wesentlich ist die Funktionsweise, dass das E-Feld im Innenbereich der Abschirmung gleich 0 ist und durch die Abschirmungsdicke der effektive Abstand verkürzt ist. Es können auch Ausführungsformen mit unterschiedlich dicken Metallabschirmungen je Sensorchip gebildet werden.

In dem erfindungsgemäßen Verfahren zur Messung des elektrischen Feldes eines stromdurchflossenen elektrischen Leiters, wird eine wie zuvor beschriebene erfindungsgemäße Vorrichtung mit einem zu vermessenden elektrischen Leiter galvanisch getrennt angeordnet. Zudem wird eine erste und eine zweite Messungen vorgenommen und

in einem Messsignalverarbeitungsschritt aus den Messwerten von erster und zweiter Messung eine weitere elektrische Größe bestimmt. Die zweite Messung wird dabei so vorgenommen, dass sie einen, durch die metallische Abschirmung bewirkt, unterschiedlichen Wert aufnimmt.

Zweckdienlicherweise wird in einer erfindungsgemäßen Ausführungsform des Verfahrens, die Bestimmung der weiteren elektrischen Größe in einem Messsignalverarbeitungsschritt ratiometrisch vorgenommen. Der Vorteil liegt unter anderem darin, dass dies unabhängig vom Abstand, beziehungsweise unabhängig von einer genauen Kenntnis des Abstands erfolgt. Der Abstand muss nicht bekannt und auch nicht reproduzierbar sein.

Insbesondere wird in dem erfindungsgemäßen Verfahren mittels der ersten und zweiten Messung je eine elektrische Feldstärke $E_1$ und $E_2$ erfasst. Im Messsignalverarbeitungsschritt wird die Spannung U unter Berücksichtigung der bekannten Dicke $d_{met}$ der metallischen Abschirmung, bestimmt, gemäß der Formel:

$$U = \frac{E_1 * E_2 * d_{met}}{E_2 - E_1}$$

Beispielsweise wird in dem erfindungsgemäßen Verfahren die Messung der elektrischen Feldstärke mittels einer mikroelektromechanischen Feldmühle vorgenommen. Dabei wird, mittels eines geerdeten Shutters, wiederholt eine Sensorelektrodenanordnung von dem zu messenden Feld abschirmt und wieder dem Feld aussetzt, so dass die Sensorelektrodenanordnung hinter dem Shutter durch Influenz des zu messenden elektrischen Feldes abwechselnd ent- und aufgeladen wird.

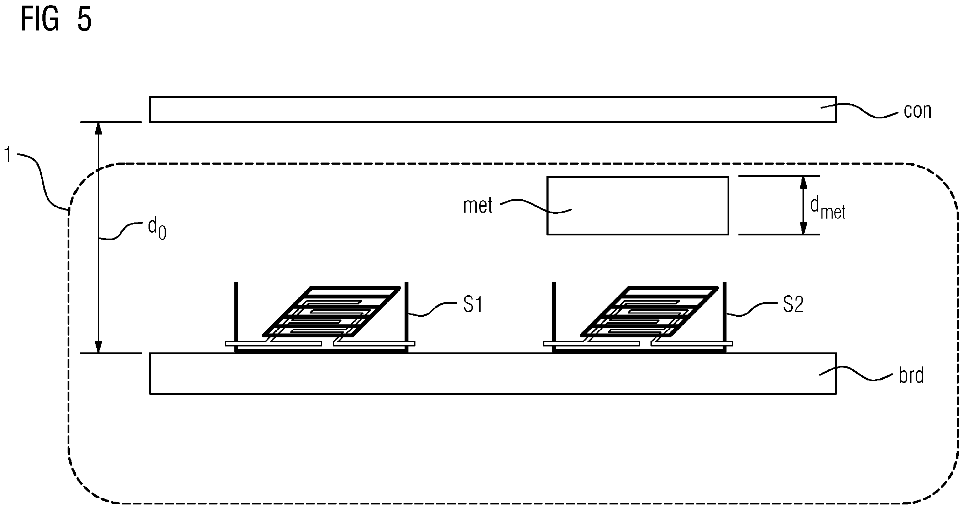

Beispiele und Ausführungsformen der vorliegenden Erfindung werden noch in exemplarischer Weise mit Bezug auf die Figuren 1 bis 5 der angehängten Zeichnung beschrieben:

Figur 1 zeigt schematisch eine Seitenansicht auf erfindungsgemäße Vorrichtung 1 und Anordnung zu elektrischem Leiter con,

Figur 2 zeigt schematisch eine Aufsicht auf eine erfindungsgemäße Vorrichtung 1,

Figur 3 zeigt eine schematische Darstellung der Elektrodenanordnung sen einer elektrischen Feldmühle S1,

Figur 4 zeigt schematisch ein E-Feld-Simulation der Messanordnung,

Figur 5 zeigt schematisch die Seitenansicht aus Figur 1 mit angedeutetem Gehäuse um die Vorrichtung 1.

In den Ausführungsbeispielen und Figuren können gleiche oder gleich wirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein.

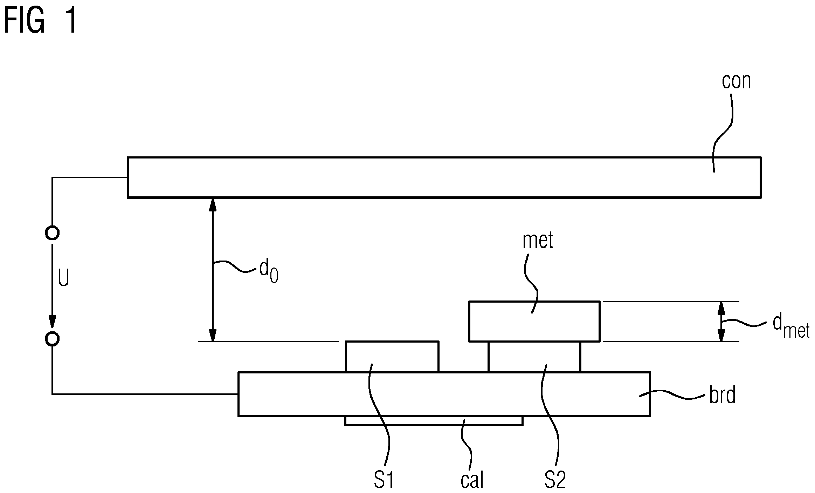

In der Figur 1 verläuft waagrecht eine Linie zur Darstellung des zu vermessenden Leiters con. An diesem liegt eine Spannung U an. Die Spannung U soll durch die Schaltungsandeutung linksseitig in der Figur 1 verdeutlicht werden. Die Vorrichtung 1 greift jedoch nicht baulich und / oder über einen elektrischen Kontakt an der Leiter con an. Die Vorrichtung 1 ist in der Nähe des Leiters con angebracht. Das elektrische Feld E eines elektrischen Leiters con fällt mit zunehmendem Abstand $d_0$. Bei der erfindungsgemäßen Vorrichtung 1 ist es unwesentlich, ob der Abstand $d_0$ bekannt ist oder reprozierbar ist. Es ist lediglich wichtig, dass die zwei Messpositionen, an denen die zwei Messwerte aufgenommen werden, die mittels ratiometrischem Verfahren verrechnet werden, in demselben Abstand $d_0$ zum Leiter con liegen. Es sind zwei Feldmesseinrichtung S1 und S2 gezeigt, welche stark vereinfacht durch Rechtecke dargestellt sind, und welche auf einem gemeinsamen Substrat brd aufgebracht sind. Eine der Feldmesseinrichtungen S2 ist durch die metallische Abschirmung met, ebenso in der Seitenansicht als Linie dargestellt, vom E-Feld E des Leiters con abgeschirmt. Die metallische Abschirmung liegt also zwischen Sensor S2 und Leiter con. Die metallische Abschirmung met weist eine Dicke $d_{met}$ auf.

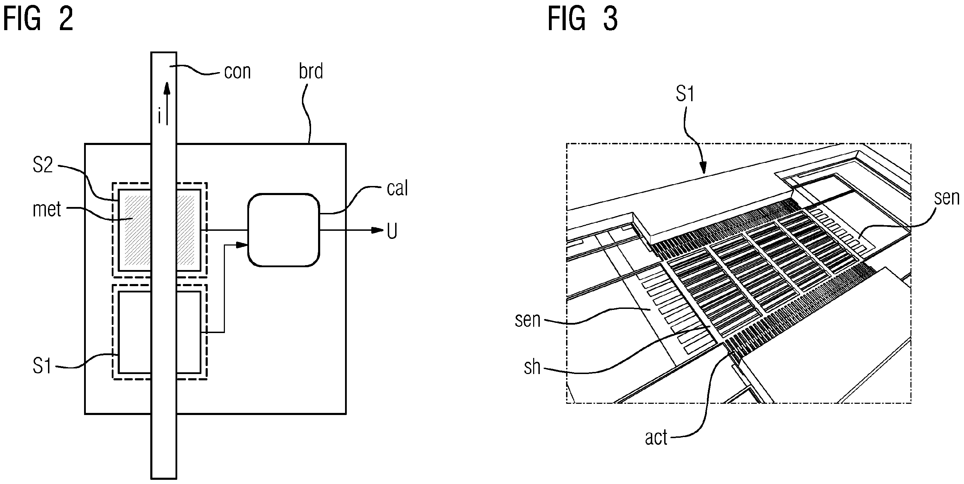

In der Figur 2 ist eine Aufsicht auf eine Vorrichtung mit Feldmesssensoren S1 und S2 gezeigt, welche ebenso auf einer Leiterplatte brd angebracht sind. Einer davon ist durch ein Metallplättchen met abgeschirmt in Richtung des E-Feld-erzeugenden stromdurchflossenen Leiters con. Zusätzlich dazu ist eine Auswerteeinheit cal gezeigt, in der die beiden Messsignale E1 und E2 der Feldmessensoren S1 und S2 verrechnet werden. Die Augabe umfasst dann beispielsweise die aus den Messungen bestimmte weitere elektrische Größe, insbesondere die am Leiter con anliegende Sapnnung U.

In der Figur 3 ist schematisch eine Sensorelektrodenanordnung sen einer elektrischen Feldmühle gezeigt.

Das Funktionsprinzip basiert auf einem geerdeten Shutter sh, der wiederholt eine Sensorelektrodenanordnung sen von einem zu messenden Feld E abschirmt und wieder dem Feld E aussetzt. Die Sensorelektroden sen sind bevorzugt als Fingerelektroden ausgeführt. Entsprechend Gaußschem Gesetz, wird die Sensorelektrodenanordnung sen hinter dem Shutter sh durch Influenz des externen elektrischen Feldes E abwechselnd ent- und aufgeladen (Verschiebestrom). Im vorliegenden Fall wird eine miniaturisierte Vorrichtung dazu vorgeschlagen.

Das Voltmeter beziehungsweise die mikroelektromechanische Feldmühle S1, S2 bestimmt die Spannung U eines Leiters con beziehungsweise dessen elektrisches Feld E durch Verschiebeströme auf zwei Sensorelektrodenflächen sen. Diese sind direkt proportional zu dem elektrischen Feld E beziehungsweise der Spannung U des zu vermessenden Leiters con. Die Messgröße Strom I ist abhängig von den Ladungsträgern Q und der Zeit $t$ zu:

$$I = \frac{\Delta Q}{\Delta t} \ .$$

Die Zeit t ist fix durch die Bauweise des Voltmeters vorgegeben. Die Ladung Q dagegen ist abhängig von der Kapazität C zwischen den Sensorelektroden sen und der Spannung U des zu vermessenden Leiters con:

$$Q = C \cdot U \ .$$

Die Kapazität C wiederum bestimmt sich in einer vereinfachten Anschauung aus der Fläche A der Sensorelektroden sen, dem Abstand zwischen Sensorelektroden sen und dem zu vermessenden Leiter $d_0$ sowie der Permittivität $\varepsilon = \varepsilon_0 \varepsilon_r$ zu:

$$C = \frac{\varepsilon_0 \varepsilon_r \cdot A}{d} \ .$$

Will man also die Empfindlichkeit des Messprinzips variieren, sind dies die möglichen Variablen. Das Messprinzip des beschriebenen mikroelektromechanischen Voltmeters basiert auf der zeitlichen Änderung der Fläche des dem Feld des zu vermessenden Leiters ausgesetzten A:

$$I(t) = U \frac{\varepsilon_0 \varepsilon_r}{d} \frac{dA}{dt}$$

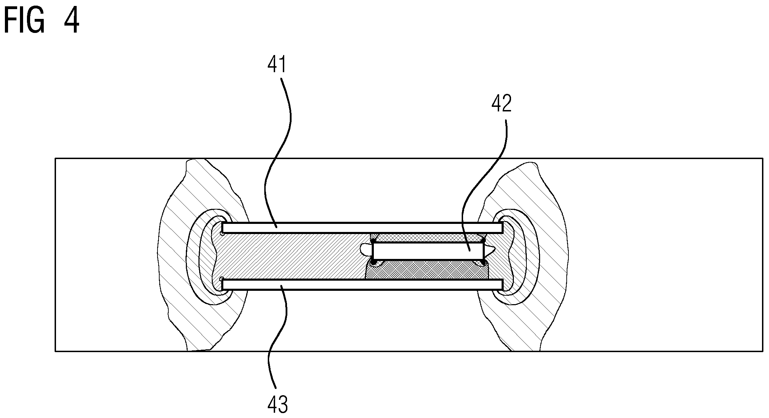

In der Figur 4 ist schließlich noch einmal die Seitenansicht der Figur 1 aufgegriffen. Die mikroelektromechanischen Feldmühlen S1 und S2 sind schematisch als Fingerelektroden angedeutet. Die gestrichelte Umrandung um die Vorrichtung 1 verdeutlicht die berührungslose Anordnung mit dem zu vermessenden Leiter con ebenso, wie die kabellose Ausführbarkeit, da kein Signal oder Strom oder Potentialausgleich mit Außerhalb der Vorrichtung 1 notwendig ist. Die Vorrichtung 1 beziehungsweise die Messsignalverarbeitungseinrichtung cal kann eine weitere Signalverarbeitungseinrichtung, z.B. auf dem gemeinsamen Schaltungsträger brd 1umfassen. Insbesondere ist die Vorrichtung 1 beziehungsweise die Messsignalverarbeitungseinrichtung cal ausgestaltet, mittels des gemeinsamen Schaltungsträgers brd auf Systemebene zu kommunizieren.

Die Vorrichtung 1 kann kabellos ausgestaltet sein, kann aber beispielsweise alternativ einen Anschluss für eine Datenausgabe aufweisen, einen Stecker, Datenanschluss oder anderes Interface, worüber insbesondere eine Kommunikation an eine Datenverarbeitungseinrichtung erfolgt, beispielsweise an einen Computer. Unter Computer können beispielsweise Personal Computer, Server, Handheld-Computer-Systeme, Pocket-PC-Geräte, Mobilfunkgeräte, Edge-Devices und andere Kommunikationsgeräte, die rechnergestützt Daten verarbeiten können, Prozessoren und andere elektronische Geräte zur Datenverarbeitung verstanden werden. Eine Datenübertragung kann aber auch kabellos erfolgen.

Beispielsweise weist die Vorrichtung 1, beziehungsweise die Messsignalverarbeitungseinrichtung cal ein BUS-System für die Zusammenführung der Messsignale E1 und E2 auf, insbesondere bei der digitalen Leistungs- und/oder Energiewertbestimmung. Alternativ weist die Messsignalverarbeitungseinrichtung cal eine Auswerteelektronik für analoge Auswertung auf.

Zusammenfassend kann festgehalten werden: Es wird eine Vorrichtung und ein Verfahren zur berührungslosen Bestimmung einer elektrischen Größe eines zu vermessenden elektrischen Leiters (con) vorgeschlagen. Mit einer Anordnung von Feldmesseinrichtung/en (S1, S2) mit wenigstens einer metallischen Abschirmung an dem zu vermessenden elektrischen Leiter (con) werden zwei Messungen des elektrischen Feldes (E1, E2) vorgenommen. Durch die bekannte Größe, die die metallische Abschirmung mit ihrer Dicke ($d_{met}$) in die Vergleichsmessung einbringt, kann das ratiometrische Messprinzip angewendet werden und, unabhängig von Kenntnissen über den Abstand der Feldmessvorrichtung vom elektrischen Leiter (con), eine elektrische Größe, insbesondere die anliegende Spannung (U) am Leiter, genau bestimmt werden.

Bezugszeichenliste

| | |
|---|---|
| $d_0$ | Abstand Leiter zu E-Feld-Detektor |
| S1 | E-Feld-Detektor 1 |
| S2 | E-Feld-Detektor 2 |
| con | zu vermessender Leiter, stromführen |
| met | Metallische Abschirmung |
| $d_{met}$ | Dicke der metallischen Abschirmung |
| U | zu bestimmender Spannungswert |
| brd | circuit board, Leiterplatte, Substrat |
| cal | Messauswerteeinheit |
| 1 | Spannungsmessvorrichtung, berührungslos zu |

vermessenden Leiter con, keine Strom- und/oder Datenleitung von extern erforderlich, einhausbar

41 obere Kondensatorplatte

42 Metallplatte

43 untere Kondensatorplatte

**Patentansprüche**

1. Vorrichtung (1) umfassend wenigstens eine Feldmesseinrichtung (S1, S2) zur Messung eines elektrischen Feldes eines zu vermessenden elektrischen Leiters (con), wobei die Feldmesseinrichtung (S1, S2) an dem zu vermessenden elektrischen Leiter (con) galvanisch getrennt zu diesem positionierbar ist, **dadurch gekennzeichnet, dass** die wenigstens eine Feldmesseinrichtung (S1, S2) mit einer metallischen Abschirmung (met) bekannter Dicke ($d_{met}$) angeordnet ist, so dass zwei Messungen des elektrischen Feldes des zu vermessenden Leiters (con) mit unterschiedlichem relativen Abstand zwischen Feldmesseinrichtung (S1, S2) und Leiter (con) vornehmbar sind.

2. Vorrichtung nach Anspruch 1, umfassend eine Messsignalverarbeitungseinrichtung (cal), welche ausgestaltet ist, aus den Messungen (E1, E2) eine weitere elektrische Größe (U) zu bestimmen.

3. Vorrichtung nach Anspruch 2, wobei die Feldmesseinrichtung (S1, S2) als mikroelektromechanische Feldmühle ausgestaltet ist.

4. Vorrichtung nach einem der vorstehenden Ansprüche, wobei die wenigstens eine Feldmesseinrichtung (S1, S2) als Sensorchip ausgeführt ist, insbesondere in einem Chipgehäuse.

5. Vorrichtung nach einem der vorstehenden Ansprüche, wobei die Messsignalverarbeitungseinrichtung (cal) eine Auswerteelektronik umfasst.

6. Vorrichtung nach einem der Ansprüche 2 bis 5, wobei die Messsignalverarbeitungseinrichtung (cal) eine Signalaufbereitung umfasst.

7. Vorrichtung nach einem der vorstehenden Ansprüche, wobei die Feldmesseinrichtung (S1, S2) mit einer zweiten Feldmesseinrichtung (S1, S2) nebeneinander angeordnet ist, dass beide denselben Abstand ($d_0$) zum zu vermessenden elektrischen Leiter aufweisen und wobei eine der Feldmesseinrichtungen (S1, S2) mit der metallischen Abschirmung (met) angeordnet ist.

8. Vorrichtung nach einem der vorstehenden Ansprüche 1 bis 6, wobei die Feldmesseinrichtung (S1, S2) zwischen zwei Messpositionen beweglich angeordnet ist, wobei eine Messposition durch die metallische Abschirmung (met) abgeschirmt ist.

9. Vorrichtung nach einem der vorstehenden Ansprüche 1 bis 6, wobei die Feldmesseinrichtung (S1, S2) mit einer beweglichen metallischen Abschirmung (met) angeordnet ist.

10. Vorrichtung nach einem der vorstehenden Ansprüche, wobei die Vorrichtung (1) in einem Gehäuse vorliegt.

11. Vorrichtung nach Anspruch 7 mit 4 und/oder 10, wobei die metallische Abschirmung (met) bekannter Dicke ($d_{met}$) am Gehäuse der Vorrichtung (1) oder an einem Chipgehäuse aufgebracht ist.

12. Verfahren zur Messung des elektrischen Feldes eines stromdurchflossenen elektrischen Leiters (con),

bei dem eine Vorrichtung (1) nach einem der vorstehenden Ansprüche mit einem zu vermessenden elektrischen Leiter (con) galvanisch getrennt angeordnet wird,
bei dem eine erste und eine zweite Messung (E1, E2) vorgenommen werden,
bei dem in einem Messsignalverarbeitungsschritt (cal) aus den Messwerten (E1, E2) von erster und zweiter Messung eine weitere elektrische Größe (U) ermittelt wird.

13. Verfahren nach Anspruch 12, bei dem in einem Messsignalverarbeitungsschritt (cal) die Bestimmung der weiteren elektrischen Größe (U) ratiometrisch vorgenommen wird.

14. Verfahren nach einem der Ansprüche 12 oder 13, bei dem mittels der ersten und zweiten Messung je eine elektrische Feldstärke (E1, E2) erfasst wird, und bei dem im Messsignalverarbeitungsschritt (cal) die Spannung (U) bestimmt wird, unter Berücksichtigung der bekannten Dicke ($d_{met}$) der metallischen Abschirmung (met), wobei

$$U = \frac{E_1 * E_2 * d_{met}}{E_2 - E_1}$$

15. Verfahren nach Anspruch 14, bei dem die Messung der elektrischen Feldstärke (E1, E2) mittels einer mikroelektromechanischen Feldmühle derart vorgenommen wird, dass mittels eines geerdeten Shutters (sh), wiederholt eine Sensorelektrodenanordnung von dem zu messenden Feld (E) abschirmt und wieder dem Feld (E) aussetzt wird, so dass die Sensorelektrodenanordnung hinter dem Shutter (sh) durch Influenz des zu messenden elektrischen Feldes (E) abwechselnd ent- und aufgeladen wird.

# FIG 1

EP 4 644 914 A1

# FIG 2

# FIG 3

EP 4 644 914 A1

FIG 4

42

41

43

FIG 5

EP 4 644 914 A1

# EUROPÄISCHER RECHERCHENBERICHT

Nummer der Anmeldung

EP 24 17 3403

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 4 724 393 A (KUMADA AKIRA [JP] ET AL) 9. Februar 1988 (1988-02-09) | 1,2,5-7, 9-13 | INV. G01R15/14 |
| Y | * Spalte 4, Zeile 6 - Spalte 11, Zeile 63; | 3,4,8 | G01R15/16 |
| A | Abbildungen 1,4,5,9a,12,13,14,16,18 * * Spalte 2, Zeile 4 - Zeile 9 * ----- | 14,15 | G01R29/12 ADD. G01R19/00 |
| X | DE 10 2008 052477 A1 (SIEMENS AG [DE]) 10. Juni 2010 (2010-06-10) | 1,3,4 | |
| Y | * Absatz [0001] - Absatz [0004]; Abbildung 1 * * Absatz [0017] - Absatz [0023] * ----- | 3,4 | |
| X | WO 2017/168608 A1 (HITACHI SYSTEMS LTD [JP]) 5. Oktober 2017 (2017-10-05) * 1. Ausführungsbeispiel; Abbildungen 1-3 * ----- | 1 | |
| X | US 2008/218172 A1 (USHIJIMA TAKASHI [JP] ET AL) 11. September 2008 (2008-09-11) | 1,8 | |
| Y | * Absätze [0002], [0044], [0045], [0050]; Abbildungen 3A,3B,5A,5B,5C * ----- | 8 | |

**RECHERCHIERTE SACHGEBIETE (IPC)**

G01R

Der vorliegende Recherchenbericht wurde für alle Patentansprüche erstellt

| Recherchenort | Abschlußdatum der Recherche | Prüfer |
|---|---|---|
| München | 19. September 2024 | Hof, Klaus-Dieter |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................

& : Mitglied der gleichen Patentfamilie, übereinstimmendes Dokument

EPO FORM 1503 03.82 (P04C03)

# EP 4 644 914 A1

## ANHANG ZUM EUROPÄISCHEN RECHERCHENBERICHT
## ÜBER DIE EUROPÄISCHE PATENTANMELDUNG NR.

EP 24 17 3403

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-09-2024

| Im Recherchenbericht angeführtes Patentdokument | Datum der Veröffentlichung | Mitglied(er) der Patentfamilie | Datum der Veröffentlichung |
|---|---|---|---|
| US 4724393 A | 09-02-1988 | KEINE | |
| DE 102008052477 A1 | 10-06-2010 | KEINE | |
| WO 2017168608 A1 | 05-10-2017 | JP WO2017168608 A1<br>WO 2017168608 A1 | 27-12-2018<br>05-10-2017 |
| US 2008218172 A1 | 11-09-2008 | US 2006267578 A1<br>US 2008218172 A1 | 30-11-2006<br>11-09-2008 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010035381 A1
- DE 102008052477 A1